(19) **Europäisches Patentamt**

**European Patent Office**

**Office européen des brevets**

(11) **EP 0 704 968 B1**

(12) **EUROPÄISCHE PATENTSCHRIFT**

(45) Veröffentlichungstag und Bekanntmachung des Hinweises auf die Patenterteilung:
**02.02.2000 Patentblatt 2000/05**

(51) Int Cl.⁷: $H03H\ 21/00$

(21) Anmeldenummer: **95115097.8**

(22) Anmeldetag: **25.09.1995**

(54) **Adaptives Netzwerk**

Adaptive circuit

Circuit adaptatif

(84) Benannte Vertragsstaaten:
**DE FR GB IT**

(30) Priorität: **28.09.1994 DE 4434723**

(43) Veröffentlichungstag der Anmeldung:
**03.04.1996 Patentblatt 1996/14**

(73) Patentinhaber: **SIEMENS AKTIENGESELLSCHAFT**
**80333 München (DE)**

(72) Erfinder:
- **Leeb, Ferenc, Dr.**
  **A-9500 Villach (AT)**
- **Lajos, Gazsi, Prof. Dr.**
  **D-40239 Düsseldorf (DE)**
- **Tonch, Reiner, Dipl.-Ing.**
  **D-81927 München (DE)**

(56) Entgegenhaltungen:
**EP-A- 0 098 748**    **DE-A- 2 060 159**
**DE-A- 3 610 383**

EP 0 704 968 B1

**Beschreibung**

Die Erfindung betrifft ein adaptives Netzwerk gemäß dem Oberbegriff des Anspruchs 1.

Derartige adaptive Netzwerke werden insbesondere bei digitalen Übertragungssystemen mit einem sogenannten "Noise-Predictor" eingesetzt, um die im Geräuschsignal vorhandene Korrelation zu reduzieren. Insbesondere aus "Design and Performance of an All Digital Adaptive, 2.048 MBIT/S Data Transmission System Using Noise-Prediction" von Graf, Huber aus IEEE, 1989, CH2692-2/89/0000-1808 bis 1812 ist in Figur 2 auf Seite 1809 der prinzipielle Aufbau eines derartigen Netzwerks mit einer Addierstufe, einer Entscheidungseinheit sowie einem adaptiven Rückkopplungszweig dargestellt. Der adaptive Rückkopplungszweig weist dabei mehrere Zustandsvariablen und mehrere Koeffizienten auf. Auch aus DE 3,610,383 ist ein Solches adaptives Netzwerk bekannt.

Insbesondere bei quantasierter Rückkopplung werden an derartige Netzwerke besonders hohe Ansprüche gestellt, da eine Verarbeitung zu Fehler-Burst-Signalen führt, welche insbesondere durch den Aufbau des Gesamtsystems bedingt sind und durch Fehlerfortpflanzung der Einzelfehler gebildet werden.

Aufgabe der vorliegenden Erfindung ist es daher ein System anzugeben, welches fehlertoleranter als bisherige Systeme ist.

Diese Aufgabe wird durch den kennzeichnenden Teil des Anspruchs 1 gelöst. Weiterbildungen sind Kennzeichen der Unteransprüche.

Die Erfindung wird nachfolgend anhand von zwei Figuren näher erläutert. Es zeigen

Figur 1    ein Blockschaltbild einer erfindungsgemäßen Anordnung, und

Figur 2    ein Ausführungsbeispiel einer erfindungsgemäßen Schaltungsanordnung gemäß Figur 1.

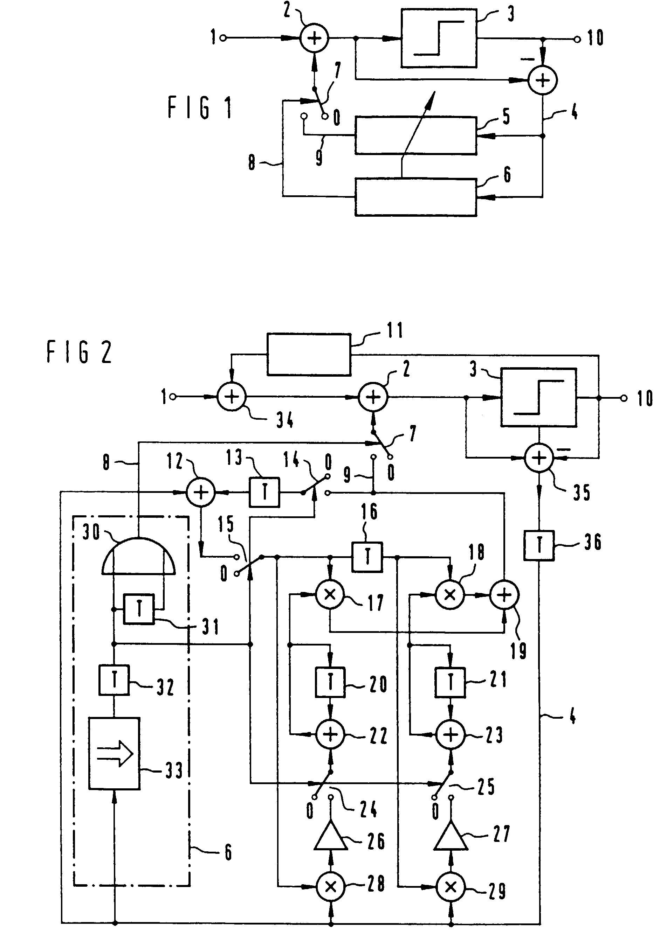

In Figur 1 ist mit 1 eine Eingangsklemme bezeichnet, die mit dem ersten Eingang eines Summierers 2 verbunden ist. Der Ausgang des Summierers ist mit dem Eingang einer Schwellenwert-Entscheidungseinheit 3 verbunden. Am Ausgang der Entscheidungseinheit 3 ist an der Klemme 10 ein Ausgangssignal abgreifbar. Das mit 4 bezeichnete Signal ist ein Summensignal von Eingangs- und negiertem Augangsignal der Entscheidereinheit, welches dem Eingang eines adaptiven Rückkopplungszweig 5 sowie einer Überwachungseinheit 6 zugeführt wird. Die Überwachungseinheit 6 erzeugt ein erstes Ausgangssignal, welches den adaptiven Rückkopplungszweig 5 steuert sowie ein zweites Ausgangssignal 8, welches einen Umschalter 7 ansteuert. Der Umschalter 7 weist zwei Umschaltkontakte auf, von denen ein erster mit dem Ausgangssignal 9 des adaptiven Rückkopplungszweigs 5 und dessen zweiter Umschaltkontakt mit einer konstanten digitalen Null beaufschlagt wird. Der Umschaltkontakt ist mit dem zweiten Eingang des Summierers 2 verbunden.

Erfindungswesentlich ist die Ausgestaltung des adaptiven Rückkopplungszweigs 5 sowie das Vorsehen des Umschalters 7 und das Vorsehen der Überwachungseinheit 6. Die Überwachungseinheit 6 ist derart ausgestaltet, daß sie das Fehlersignal 4, welches vom Entscheider 3 erzeugt wird auf bestimmte Grenzen überwacht. Überschreitet das Signal diesen Grenzbereich, so erkennt die Entscheidungseinheit ein erstes Fehlersignal. Mit dem nächsten Taktsignal werden dann die Zustandsvariablen des adaptiven Rückkopplungszweig 5 auf Null gesetzt und die Koeffizienten des adaptiven Rückkopplungszweigs 5, welche bis dahin eingespeichert waren, werden für diesen Taktzyklus eingefroren. Des weiteren wird der Umschalter 7 derart geschaltet, daß am zweiten Eingang des Summierers 2 eine digitale Null anliegt. Handelt es sich bei dem nachfolgenden Signal wiederum um ein Fehlersignal, wobei die gleiche Schwelle oder eine andere verwenden werden kann, so wird dieser Zustand weiter beibehalten. Liegen am Eingang der Überwachungseinheit 6 wieder zulässige Werte an, so wird mit dem nachfolgenden Taktzyklus zuerst der adaptive Rückkopplungszweig 5 wieder aktiviert, d.h. die Zustandsvariablen werden wieder durch die angesteuerten Signale besetzt und die Koeffizienten werden mit den bisher gespeicherten Werten weiter verarbeitet. Der Umschalter 7 bleibt jedoch noch für einen weiteren Taktzyklus in seiner "Null-Stellung" und wird somit erst mit dem übernächsten Taktzyklus wieder in seine normale Betriebsstellung umgeschaltet.

Das heißt, daß nach dem Auftreten eines unzulässigen Werts , wenn der nachfolgende Wert des Signals 4 nicht mehr einen zweiten Schwellenwert übersteigt, welcher kleiner oder gleich mit dem ersten Schwellenwert sein kann, das Signal 4 der Einheit 5 zugeführt und die Adaptation der Koeffizienten über das Steuersignal der Einheit 6 freigegeben wird. Aber die Ansteuerung der Umschalteinheit 7 bleibt zunächst solange unverändert bis die Zusatndsvariablen der Einheit 5 wieder eingeschwungen, d.h. mit Daten aus dem Signal 4 aufgefüllt sind.

Auf die zuvor beschriebene Weise können sowohl statistische Fehler gut verarbeitet werden, ohne daß der adaptive Rückkopplungszweig, d.h. der Noise-Predictor, vollständig deaktiviert wird. Burst-Signale werden durch die erfindungsgemäße Anordnung ebenso sicher erkannt und beim Auftreten wird der gesamte Rückkopplungszweig während des Burst-Signals vollständig deaktiviert. Eine Fehlersummation kann sicher verhindert werden.

Figur 2 zeigt eine Ausgestaltung der zuvor beschriebenen erfindungsgemäßen Schaltungsanordnung. Gleiche Elemente tragen gleiche Bezugszeichen. Mit 1 ist wiederum eine Eingangsklemme bezeichnet, die mit dem ersten Eingang eines zweiten Summierers 34 verbunden ist. Der Ausgang des zweiten Summierers 34 ist mit dem ersten Eingang des ersten Summierers 2 verbunden. Dieser ist wiederum mit dem Eingang der Entscheidungseinheit 3 verschaltet, an deren Ausgang über die Klemme 10 das Ausgangssignal greifbar ist. Zusätzlich ist der Ausgang des Summierers 2 mit dem ersten Eingang eines dritten Summierers 35 verbunden. Der zweite Eingang des dritten Summierers 35 wird mit dem Ausgangssignal des Entscheiders 3 mit negativem Vorzeichen beaufschlagt. Das Ausgangssignal des Entscheiders 3 wird außerdem einem Decision Feedback Equalizier 11 zugeführt, dessen Ausgangssignal dem zweiten Eingang des zweiten Summierers 34 zugeführt wird. Am Ausgang des dritten Summierers 35 ist nach einem nachgeschalteten Verzögerungsglied 36 das Fehlersignal 4 abgreifbar, welches den jeweils ersten Eingängen zweier Multiplizierer 28, 29, dem Eingang der Entscheidungseinheit 6 sowie dem ersten Eingang eines vierten Summierers 12 zugeführt wird. Der Ausgang des ersten Multiplizierers 29 wird mit einer Konstanten 27 multipliziert und dem ersten Umschaltkontakt eines zweiten Umschalters 25 zugeführt. Der zweite Umschaltkontakt des zweiten Umschalters ist wiederum mit einer digitalen Null beaufschlagt. Der Kontakt des zweiten Umschalters 25 wird mit dem ersten Eingang eines fünften Summierers 23 zugeführt, dessen Ausgang zum einen über eine erste Verzögerungseinheit 21 mit dem zweiten Eingang des fünften Summierers verbunden ist und zum anderen mit dem ersten Eingang eines dritten Multiplizierers 18. Der Ausgang des dritten Multiplizierers 18 ist mit dem ersten Eingang eines sechsten Summierers verbunden. Der Ausgang des sechsten Summierers 19 ist mit dem ersten Umschaltkontakt des Umschalters 7 verbunden und führt das Ausgangssignal des adaptiven Rückkopplungszweigs. Dieses Ausgangssignal wird dem ersten Umschaltkontakt eines dritten Umschalters 14 zugeführt, dessen zweiter Umschaltkontakt wiederum mit einer digitalen Null beaufschlagt wird. Der Mittenkontakt des dritten Umschalters 14 ist über ein zweites Verzögerungsglied 13 mit dem zweiten Eingang des vierten Summierers 12 verbunden. Der Ausgang des vierten Summierers 12 wird dem ersten Umschaltkontakt eines vierten Umschalters 15 zugeführt, dessen zweiter Umschaltkontakt wiederum mit einer digitalen Null beaufschlagt wird. Der Mittenkontakt des vierten Umschalters 15 ist zum einen mit dem ersten Eingang eines vierten Multiplizierers 17 und über ein drittes Verzögerungsglied 16 mit dem zweiten Eingang des dritten Mulitplizierers 18 verbunden. Der Ausgang des vierten Multiplizierers 17 ist mit dem zweiten Eingang des sechsten Summierers 19 verschaltet. Des weiteren ist der Mittenkontakt des vierten Umschalters 15 mit dem zweiten Eingang des zweiten Multiplizierers 28 verbunden. Der Ausgang des zweiten Multiplizierers 28 wird mit einer zweiten Konstanten 26 multipliziert und dem ersten Umschaltkontakt eines fünften Umschalters 24 zugeführt, dessen zweiter Umschaltkontakt wiederum mit einer digitalen Null beaufschlagt wird. Der Mittenkontakt des fünften Umschalters 24 ist mit dem ersten Eingang eines siebten Summierers 22 verbunden. Der Ausgang des siebten Summierers 22 ist zum einen mit dem zweiten Eingang des vierten Multiplizierers 17 und zum anderen über ein viertes Verzögerungsglied 20 mit dem zweiten Eingang des siebten Summierers 22 verbunden.

Die Entscheidungseinheit weist einen Komparator 33 auf, der das Eingangssignal hier auf obere und untere Grenze überwacht. Bei Überschreiten des vorbestimmten Bereichs gibt der Komparator eine logische "1" aus, ansonsten eine logische "0". Dieses Ausgangssignal wird einem fünften Verzögerungsglied 32 zugeführt, dessen Ausgang zum einen zweiten bis fünften Umschalter ansteuert und zum anderen dem ersten Eingang eines ODER-Gatters 30 und über ein sechstes Verzögerungsglied 31 dem zweiten Eingang des ODER-Gatters 30 zugeführt wird. Das Ausgangssignal des ODER-Gatters 30 bildet das Ausgangssignal 8 der Entscheidungseinheit und steuert den ersten Umschalter 7.

Der adaptive Rückkopplungszweig besteht aus den Elementen 12 bis 29 und weist das erste und vierte Verzögerungsglied 20 und 21 auf, welche die aktuellen Koeffizienten speichern. Diese Koeffizienten können durch die Formel

$$K_{20/21}(n) = K_{20/21}(n-1) + \mu \cdot T_{36} \cdot S_{15/16}$$

angegeben werden. Mit K ist der jeweilige in der Verzögerungseinheit 20 bzw. 21 gespeicherte Koeffizient und mit u die Konstante 26 bzw. 27 bezeichnet. $T_{36}$ bezeichnet das Ausgangssignal des Verzögerungsglieds 36 und $S_{15/16}$ das jeweilige dem anderen Eingang des Multiplizierers 28 bzw. 29 zugeführte Signal. n bezeichnet den jeweiligen Taktzyklus. Die Zustandsvariablen werden durch die zweite und dritte Verzögerungseinheit definiert. Diese Einheiten sind wiederum als Speicher ausgebildet.

Zum Zurücksetzen der Zustandsvariablen auf Null sind die Umschalter 14 und 15 vorgesehen, welche im Fall der Ansteuerung die Eingänge der Verzögerungsglieder 13 und 16 auf Null setzen. Zum Einfrieren der Koeffizienten sind die Umschalter 24 und 25 vorgesehen, welche ein Aufaddieren der Koeffizienten 20, 21 mit Null bewirken, wodurch der jeweilige Inhalt in den Speichereinheiten 20, 21 erhalten bleibt.

Erkennt der Komparator 33 ein Fehler-Signal, welches außerhalb der definierten Grenzen liegt, so wird an seinem Ausgang eine logische "1" erzeugt. Im Normalbetrieb erzeugt der Komparator 33 eine logische "0" was wiederum bewirkt, daß am Ausgang des ODER-Gatters 30 ebenfalls eine logische "0" anliegt und alle Umschalter 7, 24, 25, 14, 15 geschlossen sind. Liegt eine logische "1" am Ausgang des Komparators 33 an, so wird diese mit dem nächsten Taktzyklus von der Speichereinheit 32 übernommen und am ersten Eingang des ODER-Gatters 30 und an dessen Ausgang liegt ein logisches "1"-Signal an, was bewirkt, daß die Umschalter 7, 14, 15, 24, 25 geöffnet werden und deren Mittelkontakte mit einer Null beaufschlagt werden. Tritt mit dem nächsten Signal 4 kein Fehlersignal auf, d.h. liegt das Signal 4 innerhalb der definierten Grenzen, so erfolgt am Ausgang des Komparators 33 wieder die Ausgabe eines Nullsignals und mit dem nachfolgenden Taktzyklus wird dieses auf den ersten Eingang des ODER-Gatters 30 übernommen und somit die Umschalter 14, 15, 24, 25 wieder geschlossen. Durch die zweite Speichereinheit 31 wird jedoch das zuvor anliegende Eins-Signal auf den zweiten Eingang des ODER-Gatters 30 geleitet und der Umschalter 7 bleibt für diesen Taktzyklus noch offen. Erst mit einem weiteren nachfolgenden regulären Signal 4 wird auch dieser Umschalter 7 wieder geschlossen.

**Patentansprüche**

1. Adaptives Netzwerk mit einem ersten Summationsknoten (2), dem ein Eingangssignal (1) zugeführt wird und dessen Ausgangssignal einer Entscheidungseinheit (3) zugeführt wird, an deren Ausgang (10) ein Ausgangssignal abgreifbar ist, mit einem zweiten Summationsknoten, welcher ein Differenzsignal (4) zwischen Ausgang- und Eingangsignal der Entscheidereinheit bildet und einem adaptiven Rückkopplungszweig (5) mit Zustandsvariablen (13, 16) und Koeffizienten (20, 21) zugeführt wird, dessen Ausgang mit dem Summationsknoten (2) gekoppelt ist, **dadurch gekennzeichnet,** daß eine Überwachungseinheit (6) vorgesehen ist, die die Fehlergröße des Differenzsignals (4) der Entscheidungseinheit (3) überwacht und bei Auftreten eines ersten Signalwertes, dessen Amplitude einen bestimmten Schwellenwert übersteigt, im nachfolgenden Taktzyklus einen im zwischen Rückkopplungszweig (5) und Summationsknoten (2) befindlichen Umschalteinheit (7) derart ansteuert, daß der Summationsknoten mit einem digitalen Null-Signal beaufschlagt wird sowie die Zustandsvariablen des Rückkopplungszweigs (5) auf Null setzt und die Koeffizienten (20, 21) des Rückkopplungszweigs (5) einfriert.

2. Adaptives Netzwerk nach Anspruch 1, **dadurch gekennzeichnet,** daß wenn der Folgewert des Differenzsignals (4) nicht mehr einen zweiten Schwellenwert übersteigt, welcher kleiner oder gleich mit dem ersten Schwellenwert sein kann, das Differenzsignal (4) zur Einheit (5) zugeführt und die Adaptation der Koeffizienten freigegeben wird, wobei die Ansteuerung der Umschalteinheit (7) zunächst solange unverändert bleibt, bis die Zusatndsvariablen des Rückkopplungszweigs (5) wieder eingeschwungen sind.

3. Adaptives Netzwerk nach Anspruch 1 oder 2, **dadurch gekennzeichnet,** daß die Zustandsvariablen als Speichereinheiten (13, 16) ausgebildet sind, denen jeweils ein Umschalter (14, 15) vorgeschaltet ist, der wahlweise mit dem signalführenden Pfad bzw. mit einem digitalen Null-Signal beaufschlagt wird, wobei der Umschalter durch die Überwachungseinheit (6) gesteuert wird.

4. Adaptives Netzwerk nach einem der vorhergehenden Ansprüche, **dadurch gekennzeichnet,** daß die Koeffizienten in jeweils einer Speichereinheit (20, 21) gespeichert werden, deren Ausgang mit dem ersten Eingang eines zugehörigen Summierers (22, 23) verbunden ist, dessen Ausgang mit dem Eingang der Speichereinheit (20, 21) verbunden ist und dessen zweiter Eingang mit einem Umschalter (24) verbunden ist, dessen erster Umschaltkontakt mit dem Signalpfad verbunden ist und dessen zweiter Umschaltkontakt mit einem digitalen Null-Signal beaufschlagt wird, wobei der Umschalter vom Ausgangssignal der Überwachungseinheit gesteuert wird.

5. Adaptives Netzwerk nach einem der vorhergehenden Ansprüche, **dadurch gekennzeichnet,** daß die Überwachungseinheit einen Komparator (33) zur Überwachung vorbestimmter Grenzbereiche des Differenzsignals (4) aufweist, dessen Ausgangssignal einer ersten Speichereinheit (32) zugeführt wird, deren Ausgang das Ausgangssignal zur Steuerung des Rückkopplungszweigs dient, wobei das Ausgangssignal der Speichereinheit (32) zum einen mit dem ersten Eingang eines ODER-Gatters (30) verbunden ist und zum anderen über eine weitere Speichereinheit (31) mit dem zweiten Eingang des ODER-Gatters (30) verbunden ist, und das Ausgangssignal des ODER-Gatters (30) zur Steuerung der Umschalteinheit (7) dient.

**Claims**

1. Adaptive network having a first summation node (2) to which an input signal (1) is supplied and whose output signal is supplied to a decision unit (3), at whose output (10) an output signal can be tapped off, having a second summation node, which forms a difference signal (4) between the output signal and the input signal of the decision unit and which is supplied to an adaptive feedback path (5) with state variables (13, 16) and coefficients (20, 21), whose output is coupled to the summation node (2), characterized in that a monitoring unit (6) is provided which monitors the error magnitude of the difference signal (4) from the decision unit (3) and, if a first signal value occurs whose amplitude exceeds a specific threshold value, actuates, in the next clock cycle, a changeover unit (7), which is located in between the feedback path (5) and the summation node (2), in such a manner that the summation node has a digital zero signal applied to it and sets the state variables of the feedback path (5) to zero as well as freezing the coefficients (20, 21) of the feedback path (5).

2. Adaptive network according to Claim 1, characterized in that, if the subsequent value of the difference signal (4) no longer exceeds a second threshold value which may be less than or equal to the first threshold value, the difference signal (4) is supplied to the unit (5) and the adaptation of the coefficients is enabled, in which case the actuation of the changeover unit (7) initially remains unchanged until the state variables of the feedback path (5) have reached the steady state again.

3. Adaptive network according to Claim 1 or 2, characterized in that the state variables are in the form of memory units (13, 16) upstream of each of which a changeover switch (14, 15) is connected, which optionally has applied to it the path which carries the signal or a digital zero signal, in which case the changeover switch is controlled by the monitoring unit (6).

4. Adaptive network according to one of the preceding claims, characterized in that the coefficients are stored in in each case one memory unit (20, 21), whose output is connected to the first input of an associated adder (22, 23), whose output is connected to the input of the memory unit (20, 21) and whose second input is connected to a changeover switch (24) whose first changeover contact is connected to the signal path and whose second changeover contact has a digital zero signal applied to it, in which case the changeover switch is controlled by the output signal from the monitoring unit.

5. Adaptive network according to one of the preceding claims, characterized in that the monitoring unit has a comparator (33) for monitoring predetermined limit regions of the difference signal (4), whose output signal is supplied to a first memory unit (32), whose output acts as the output signal for controlling the feedback path, in which case the output signal of the memory unit (32) is on the one hand connected to the first input of an OR gate (30) and on the other hand is connected via a further memory unit (31) to the second input of the OR gate (30), and the output signal from the OR gate (30) is used to control the changeover unit (7).

## Revendications

1. Circuit adaptatif avec un premier noeud additionneur (2), sur lequel est amené un signal d'entrée (1) et dont le signal de sortie est conduit à une unité de prise de décision (3), sur la sortie (10) de laquelle on peut prélever un signal de sortie, avec un deuxième noeud additionneur qui forme un signal différentiel (4) entre le signal de sortie et le signal d'entrée de l'unité de prise de décision et avec une branche adaptative de contre-réaction (5), avec des variables d'état (13, 16) et des coefficients (20, 21), dont la sortie est couplée au noeud additionneur (2), **caractérisé par le fait** qu'il est prévu une unité de surveillance (6) qui surveille l'importance de l'erreur du signal différentiel (4) de l'unité de prise de décision (3) et que, lorsqu'il apparaît une première valeur de signal dont l'amplitude dépasse un certain seuil, une unité de commutation (7), qui se trouve entre la branche de contre-réaction (5) et le noeud additionneur (2), est excitée, au cours du cycle de synchronisation suivant, de telle sorte que le noeud additionneur reçoit un signal numérique zéro et remet à zéro les variables d'état de la branche de contre-réaction (5) et gèle les coefficients (20, 21) de la branche de contre-réaction (5).

2. Circuit adaptatif selon la revendication 1 **caractérisé par le fait** que, lorsque la valeur suivante du signal différentiel (4) ne dépasse plus un deuxième seuil, qui peut être égal ou inférieur au premier seuil, le signal différentiel (4) est appliqué à l'unité (5) et l'adaptation des coefficients est validée, l'excitation de l'unité de commutation (7) restant d'abord inchangée tant que les variables d'état de la branche de contre-réaction (5) ne sont pas rétablies.

3. Circuit adaptatif selon la revendication 1 ou 2 **caractérisé par le fait** que les variables d'état sont conçues sous forme d'unité de mémoire (13, 16), précédées respectivement d'un commutateur inverseur (14, 15) qui peut être commuté au choix sur le chemin qui porte le signal ou sur un signal numérique zéro, le commutateur inverseur étant commuté par l'unité de surveillance (6).

4. Circuit adaptatif selon l'une des revendications précédentes **caractérisé par le fait** que les coefficients sont mémorisés chacun dans une unité de mémoire (20, 21), dont la sortie est reliée à la première entrée d'un additionneur correspondant (22, 23), dont la sortie est reliée à l'entrée de l'unité de mémoire (20, 21) et dont la deuxième entrée est reliée à un commutateur inverseur (24), dont le premier contact inverseur est relié au chemin qui porte le signal et dont le deuxième contact inverseur reçoit un signal numérique zéro, le commutateur inverseur étant commandé par le signal de sortie de l'unité de surveillance.

5. Circuit adaptatif selon l'une des revendications précédentes

 **caractérisé par le fait** que l'unité de surveillance comporte, pour la surveillance de plages limites prédéfinies pour le signal différentiel (4), un comparateur (33) dont le signal de sortie est amené sur une première unité de mémoire (32), dont la sortie offre le signal de sortie pour la commande de la branche de contre-réaction, le signal de sortie de l'unité de mémoire (32) étant reliée, d'une part, à la première entrée d'une porte "OU" (30) et, d'autre part, à travers une autre unité de mémoire (31), à la deuxième entrée de la porte "OU" (30) et le signal de sortie de la porte "OU" (30) servant à la commande de l'unité de commutation (7).

FIG 1

FIG 2